# EUROPEAN PATENT APPLICATION

(11) **EP 4 727 328 A1**
(43) Date of publication of application: **15.04.2026**
(21) Application number: 25204641.2
(22) Date of filing: 25.09.2025
(51) Int. Cl.: H10W 70/60, H10W 70/00

(54) **METHOD FOR MAKING A DUAL SIDE PLATING PANEL LEVEL PACKAGE**

(30) Priority: 10.10.2024 US 202463705699 P; 17.09.2025 US 202519331321
(71) Applicant: STMicroelectronics International N.V., 1228 Plan-les-Ouates, Geneva (CH)
(72) Inventor: CHEN, Chun Hao, 220028 NEW TAIPEI CITY (TW); GANI, David, 689527 CHOA CHU KANG (SG)
(74) Representative: Casalonga

(57) **Abstract**

To form an integrated circuit package, an integrated circuit die is laterally encapsulated a by a first encapsulating body. A first plating layer, including first conductive lines and a second encapsulating body, is formed over coplanar faces of the IC die and first encapsulating body. From the opposite coplanar faces, via openings are formed extending through the first encapsulating body to the first conductive lines. A second plating layer, including second conductive lines and a third encapsulating body, is formed over the opposite coplanar faces, with the second plating layer filling the via openings and electrically connecting to the IC die.

## Description

### CROSS REFERENCE TO RELATED APPLICATIONS

This application claims priority from United States Provisional Application for Patent No. 63/705,699, filed October 10, 2024, the content of which is incorporated here by reference.

### TECHNICAL FIELD

The present invention generally relates to integrated circuit packaging and, more particularly, to a method of making an integrated circuit package having dual (front and back) sided plating in a panel level package.

### BACKGROUND

Reference is made to United States Patent Application Publication No. 2022/0285256, incorporated herein by reference, as exemplary of a prior art panel level packaging method for producing packaged integrated circuits.

### SUMMARY

In an embodiment, a method comprises: mounting a plurality of integrated circuit (IC) dies upper face down to a first carrier panel; placing the first carrier panel with the plurality of IC dies in a first mold cavity; injecting an encapsulation material into the first mold cavity to laterally encapsulate the plurality of IC dies with a first encapsulating body; forming a first plating layer over lower faces of the plurality of IC dies and first encapsulating body, said first plating layer including first conductive lines encapsulated in a second encapsulating body; removing the first carrier panel; mounting a second carrier panel to the second encapsulating body of the first plating layer; forming first via openings from an upper face of the first encapsulating body through the first encapsulating body to reach back surfaces of the first conductive lines; and forming a second plating layer over the upper face of the first encapsulating body, said second plating layer including conductive vias filling the first via openings and second conductive lines encapsulated in a third encapsulating body and electrically connected to the plurality of IC dies.

### BRIEF DESCRIPTION OF THE DRAWINGS

For a better understanding of the embodiments, reference will now be made by way of example only to the accompanying figures in which:
Figure 1 shows a cross-sectional view of an integrated circuit package;
Figure 2 shows a cross-sectional view of an integrated circuit package; and
Figures 3A-3Q show steps in a process for manufacturing an integrated circuit package like that shown in Figures 1 and 2.

### DETAILED DESCRIPTION

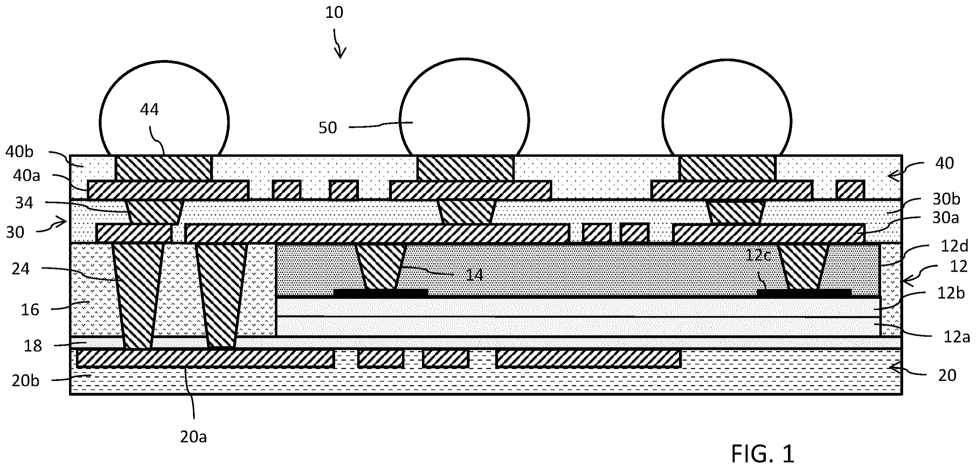

Reference is now made to Figure 1 which shows a cross-sectional view of a panel level integrated circuit package 10. The package 10 secures and encloses an integrated circuit (IC) die 12 having a semiconductor (for example, silicon) substrate 12a with integrated circuitry (not explicitly shown), an interconnection layer 12b with die pads 12c (the interconnection layer 12b including interconnection structures (lines, vias, etc.) for electrically connecting the die pads 12c to the integrated circuitry), and a first encapsulation body 12d which covers the interconnection layer 12b including the die pads 12c. This first encapsulation body 12d may comprise an insulating film layer (such as, for example, of the Ajinomoto Build-up Film (ABF) type).

Vias 14 are provided at the upper surface of the first encapsulation body 12d which extend through the first encapsulation body thickness to make physical contact with and electrical connection to the die pads 12c.

The side edges of the first encapsulation body 12d are aligned with the side edges of the interconnection layer 12b and substrate 12a.

The IC die 12 may be manufactured using wafer scale processing techniques where a semiconductor wafer (including multiple instances of the integrated circuitry), with an overlying interconnection layer and a covering film layer of the first encapsulation is processed at wafer scale, including the formation of at least the openings for the vias 14, and subjected to a singulation operation which dices the processed wafer at scribing or cutting lines to produce a plurality of singulated IC dies, one of which, referenced 12 herein, being shown in the figure.

A part of the processing operation for making the package 10 may include a thinning of the wafer substrate from the back side, where the back side processing to thin the wafer substrate is made possible with the structural support provided during processing by the covering film layer which provides the first encapsulation 12d. This back side thinning is performed at wafer scale prior to singulation.

The IC die 12 is laterally encapsulated by a second encapsulation body 16. The upper surface of the second encapsulation body 16 is coplanar with the upper surface of the first encapsulation body 12d at the front side of the interconnection layer 12b, and the lower surface of the second encapsulation body 16 may be coplanar with the lower (i.e., back side) surface of the substrate 12a of the IC die 12.

The structure of the IC die 12 with the lateral second encapsulation body 16 may be manufactured using panel scale processing techniques where a plurality of IC dies 12 are secured to a panel carrier and placed within a mold cavity. The material for forming the second encapsulation 16 is then injected into the mold cavity and cured. A subsequent singulation operation can be performed to dice the panel and separate the IC dies 12 encapsulated by the second encapsulation body 16 from each other.

A part of the processing operation for making the package 10 may include a thinning of the encapsulated panel from the back side, where the back side processing will effectively thin the semiconductor substrate 12a with the structural support provided during processing by the panel carrier and the lateral second encapsulation body 16.

The back side of the structure of the IC die 12 with the lateral second encapsulation body 16 is covered by an insulating layer 18. This layer 18 may comprise a dielectric film, or may comprise a portion of the lateral second encapsulation body 16 which covers the back side of the IC die 12 and provides a planar back side surface.

In an alternative embodiment, the layer 18 may be omitted.

A first plating (for example, redistribution) layer 20 is provided over the insulating layer 18 (or directly over body 16 and substrate 12a if layer 18 is omitted and the surfaces of body 16 and substrate 12a are coplanar). This first plating layer 20 includes electrically conductive lines 20a formed by selectively plating an electrically conductive material (such as copper). The electrically conductive lines 20a are at least laterally encapsulated by, and perhaps further covered by (as shown), a third encapsulation body 20b. This third encapsulation body may be provided, for example, through a molding process or through a lamination process.

In an embodiment, the electrically conductive lines 20a of the first plating layer 20 may be patterned to form an electromagnetic radiation structure such as an antenna (where the antenna is electrically connected to the integrated circuit die 12 in the manner described herein). Alternatively, the electrically conductive lines 20a of the first plating layer 20 may be patterned to form an electromagnetic shield (where the shield can be electrically connected a reference voltage circuit node).

A plurality of through encapsulation vias 24 are provided at the upper surface of the second encapsulation body 16 which extend through the second encapsulation body 16 thickness and the insulating layer 18 (if present) thickness to make physical contact with and electrical connection to portions of the electrically conductive lines 20a for the first plating layer 20. Certain through encapsulation vias 24 may be used in connection with making an electrical connection of the electrically conductive lines 20a to the integrated circuit die 12, and certain other through encapsulation vias 24 may be used in connection with making an electrical connection of the electrically conductive lines 20a to package connection pads.

A second plating (for example, redistribution) layer 30 is provided over the upper surface of the second encapsulation 16 and the front side of the integrated circuit die 12. This second plating layer 30 includes electrically conductive lines 30a formed by selectively plating electrically conductive material (such as copper). The electrically conductive lines 30a are at least laterally encapsulated by, and perhaps further covered by (as shown), by a fourth encapsulation body 30b. Portions of the electrically conductive lines 30a for the second plating layer 30 make physical contact with and electrical connection to the vias 14 and the through encapsulation vias 24.

In an embodiment, the electrically conductive lines 30a, the vias 14 and the through encapsulation vias 24 are simultaneously formed using a same plating operation which fills the via openings and produces the lines.

Vias 34 are provided at the upper surface of the fourth encapsulation body 30b which extend through the fourth encapsulation body 30b thickness to make physical contact with and electrical connection to portions of the electrically conductive lines 30a. The vias 34 are formed by selectively plating electrically conductive material (such as copper) to fill via openings in the fourth encapsulation body 30b.

A third plating (redistribution) layer 40 is provided over the upper surface of the fourth encapsulation 30b. This third plating layer 40 includes electrically conductive lines 40a formed by selectively plating electrically conductive material (such as copper). The electrically conductive lines 40a are at least laterally encapsulated by, and perhaps further covered by (as shown), a fifth encapsulation body 40b. Portions of the electrically conductive lines 40a for the third plating layer 40 make physical contact with and electrical connection to the vias 34.

Electrical connection pads 44 are provided at the upper surface of the fifth encapsulation body 40b which extend through the fifth encapsulation body 40b thickness to make physical contact with and electrical connection to the electrically conductive lines 40a. The pads 44 are formed by selectively plating electrically conductive material (such as copper) to fill pad openings in the fifth encapsulation body 40b.

In an embodiment, the electrical connection pads 44 may instead be provided at the upper surface of the fourth encapsulation body 30b (in which case the third plating (redistribution) layer 40 is omitted).

Bonding balls 50 (or pillars) are provided at the package electrical connection pads 44. The package 10 may be mounted to a substrate, such as a printed circuit board, for example, using the bonding balls 50.

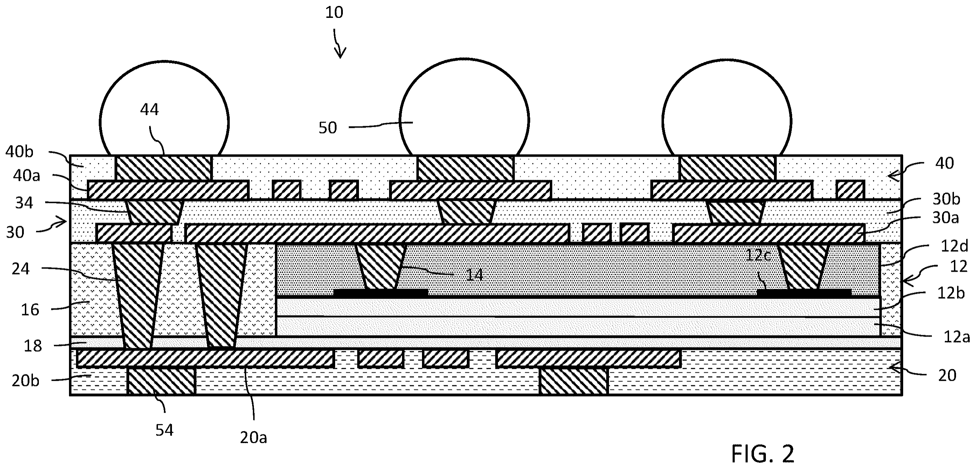

Reference is now made to Figure 2 which shows a cross-sectional view of an integrated circuit package 100. Like references in Figures 1 and 2 refer to same or similar parts the description of which is already provided above and will not be repeated here. The integrated circuit package 100 of Figure 2 differs from the integrated circuit package 10 of Figure 1 in that package 100 further includes vias 54 provided at the lower surface of the third encapsulation body 20b which extend through the third encapsulation body 20b thickness to make physical contact with and electrical connection to the electrically conductive lines 20a. The vias 54 provide electrical contact pads for supporting the mounting and electrical connection of a further electrical component (such as an integrated circuit die or a surface mount device to the integrated circuit package 100). The vias 54 are formed by selectively plating electrically conductive material (such as copper) to fill via openings in the third encapsulation body 20b.

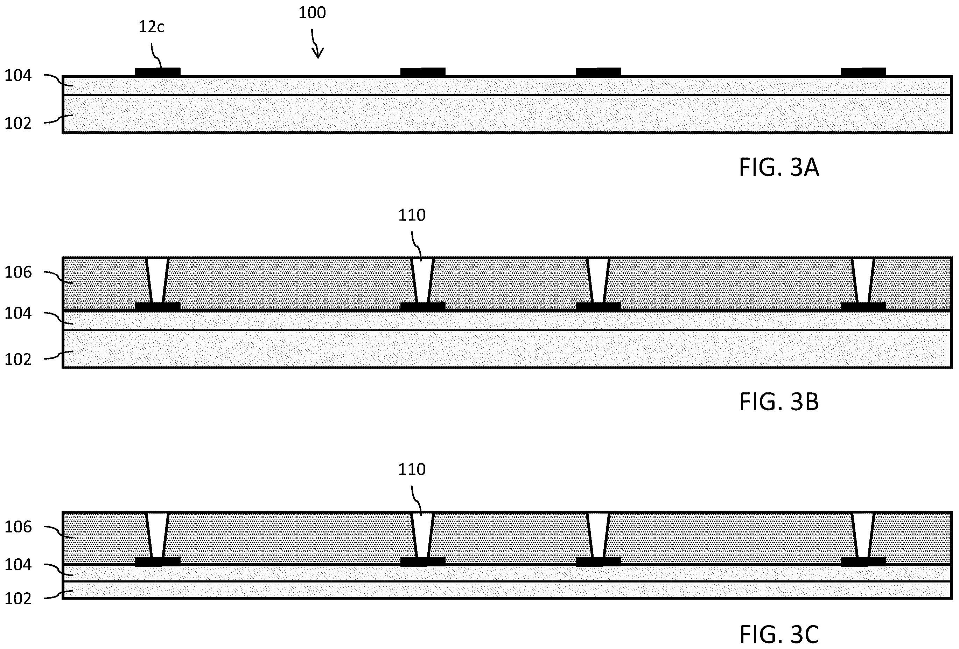

Figures 3A-3Q show steps in a process for manufacturing an integrated circuit package like that shown in Figures 1 and 2.

Figure 3A - a wafer 100 includes a semiconductor, for example silicon, substrate 102 and an interconnection layer 104 with die pads 12c (the interconnection layer 104 including interconnection structures (lines, vias, etc.) for electrically connecting the die pads 12c to integrated circuitry within the substrate 102). There are a plurality of integrated circuitry areas on the wafer delimited from each other by scribe lines.

Figure 3B - an insulating film layer 106 (such as, for example, of the Ajinomoto Build-up Film (ABF) type) covers the wafer 100. The wafer 100 covered by the film layer 106 is then processed in a laser drilling operation, or other suitable process, to open a plurality of via holes 110 extending through the insulating film layer 106 to reach the upper surface of the die pads 12c. In an embodiment, the via holes 110 are left open, to be filled later in the manufacturing process. Alternatively, the via holes 110 may be filled with a conductive material (for example, copper) using a plating operation.

Figure 3C - a handle (not explicitly shown) is mounted to the frontside of the wafer 100 and a back side grinding or polishing operation is performed on the wafer to reduce the thickness of the substrate 102.

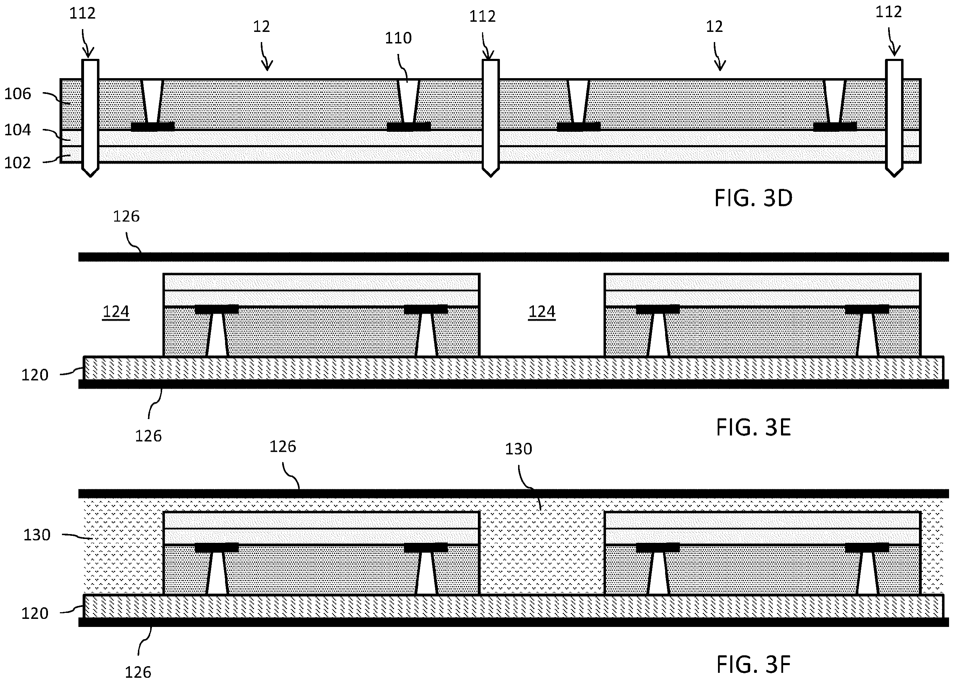

Figure 3D - the thinned wafer 100 covered by the film layer 106 is then processed in a singulation operation by cutting 112 (for example, dicing) the wafer into a plurality of individual integrated circuit (IC) dies 12. The cutting may be performed by a sawing action taken along the scribe line locations between the locations of the integrated circuitry. The dicing of the wafer defines the substrate 12a, interconnect layer 12b and the first encapsulation body 12d for the integrated circuit die 12.

Figure 3E - plural IC dies 12 are mounted upper face down to a carrier panel 120. The panel 120 with the mounted IC dies 12 is then placed with a cavity 124 of a two part mold 126.

Figure 3F - an encapsulation material 130 is injected into the cavity 124 and allowed to cure so as to laterally encapsulate each of the IC dies 12 as well as cover the back sides of the IC dies 12. This encapsulation material 130 provides the encapsulating body 16 of each package 10.

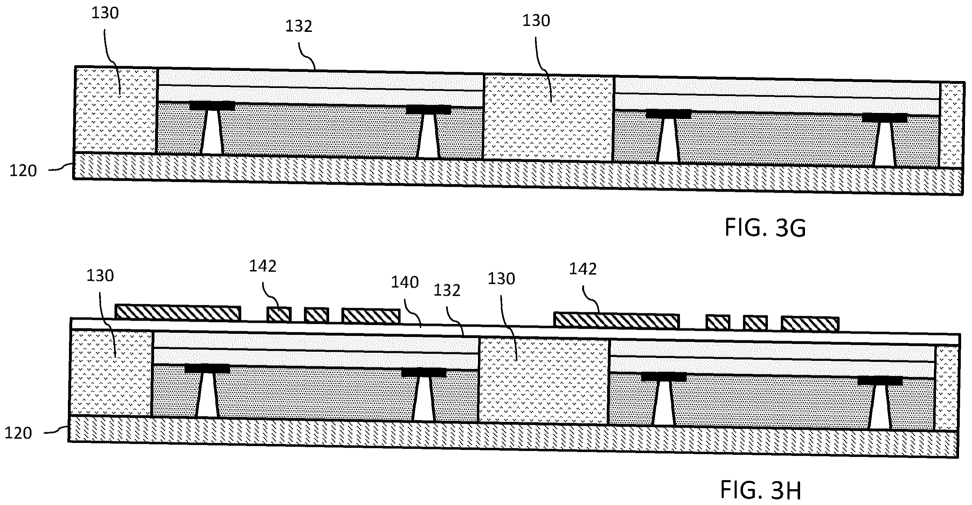

Figure 3G - the laterally encapsulated plurality of IC dies 12 mounted to the panel 120 are removed from the mold 126. If necessary, a grinding operation can be performed at the back side 132 to ensure a planar back surface. The grinding operation may also be used to remove the excess encapsulation material 130 layer at the back surfaces of the IC dies 12 (and thus provide coplanar surfaces of the encapsulation material 130 and the plurality of IC dies 12 at the coplanar back side 132). This back side grind may also, if needed, further reduce the thickness of the substrate 12a for each die 12. The issue of thickness is important as it is necessary to provide the panel structure where the thickness of the encapsulation material 130 is thin enough to permit the formation of through via openings as will be described below.

Figure 3H - in an embodiment, an insulating dielectric layer 140 may be formed on the coplanar back side 132. This layer 140 provides the layer 18 of each package 10. Alternatively, the layer of the encapsulation material 130 covering the back sides of the IC dies 12 may be used to provide the layer 140 with the planar surface.

As previously noted, the layer 18 may be omitted. In such a case, the insulating dielectric layer 140 would not be formed on the coplanar back side 132.

The first plating (redistribution) layer 20 is then formed on the planar surface of layer 140. Using conductive material deposition (for example, sputtering, plating, etc.) and lithographic processing techniques (for example, patterning, etching, etc.), a plurality of conductive lines 142 are formed on the layer 140 (or directly on the coplanar back side 132 in the case where layer 140 is omitted). In an embodiment, a conductive seed layer is deposited (for example, by sputtering) and lithographically patterned. A plating process is then performed to plate copper material on the lithographically patterned seed layer to form the conductive lines 142.

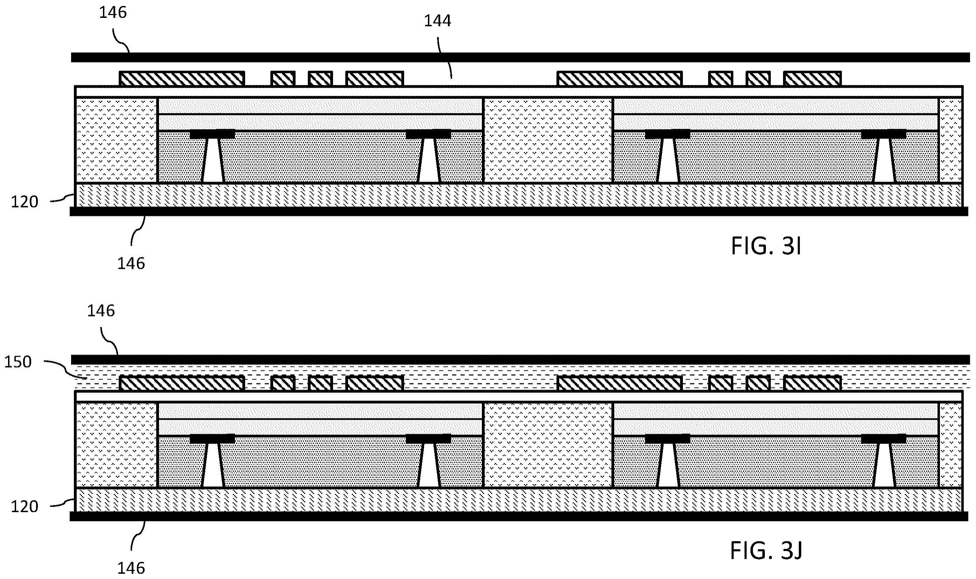

Figure 3I - the panel 120 with the mounted laterally insulated IC dies 12 with back side conductive lines 142 is then placed within a cavity 144 of a two part mold 146.

Figure 3J - an encapsulation material 150 is injected into the cavity 144 and allowed to cure so as to encapsulate the back side conductive lines 142.

The conductive lines 142 and the encapsulation material 150 provide the structures for the lines 20a and third encapsulation body 20b of the first plating (redistribution) layer 20 for each package 10.

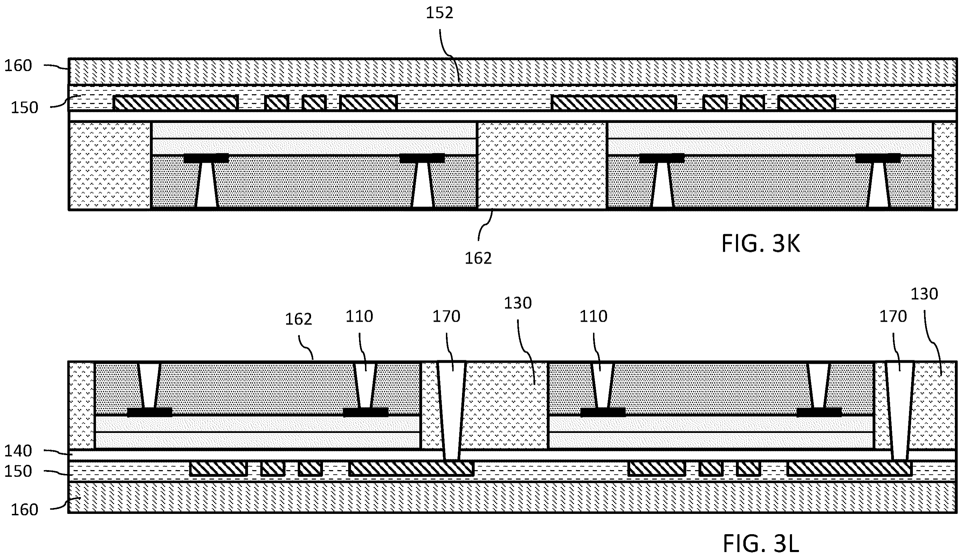

Figure 3K - the panel structure formed in the processing step of Figure 3J is removed from the mold 146.

For the embodiment of Figure 2, vias 54 are then formed in the encapsulation 150 to reach the conductive lines 142. These vias 54 may be formed using a lithographic process such as: after formation of the conductive lines 142, a lithographic process plus plating is performed to create the vias 54 followed by the formation of material encapsulating the lines 142 and vias 54, followed by a grinding or thinning process on the encapsulation material to expose a surface of the vias 54 and provide a planar mounting surface and define the third encapsulation body 20b.

In an alternative implementation, after formation of the conductive lines 142, there is a formation of material encapsulating the lines 142, followed by a grinding or thinning process on the encapsulation material to provide a planar surface and define the third encapsulation body 20b, then via openings are laser drilled through the encapsulation material to reach the lines 142, followed by an electroplating of the via openings to form the vias 54. A polishing or planarization (CMP, for example) may then be performed to provide coplanar surfaces of the vias 54 and third encapsulation body 20b.

A further carrier panel 160 is mounted to the back side 152 of the encapsulation material 150, and the carrier panel 120 is removed. This exposes the coplanar front side 162 of the laterally encapsulated plurality of IC dies 12 and exposes the open holes 110 (if not already filled) in the first encapsulation body 12d.

Figure 3L - the structure mounted to the carrier panel 160 is then flipped upside-down. Laser processing is used to drill via openings 170 in the encapsulation material 130 from the front side 162. These via openings 170 extend completely through both the encapsulation material 130 and the insulating dielectric film 140 layer to reach the undersides of the back side conductive lines 142.

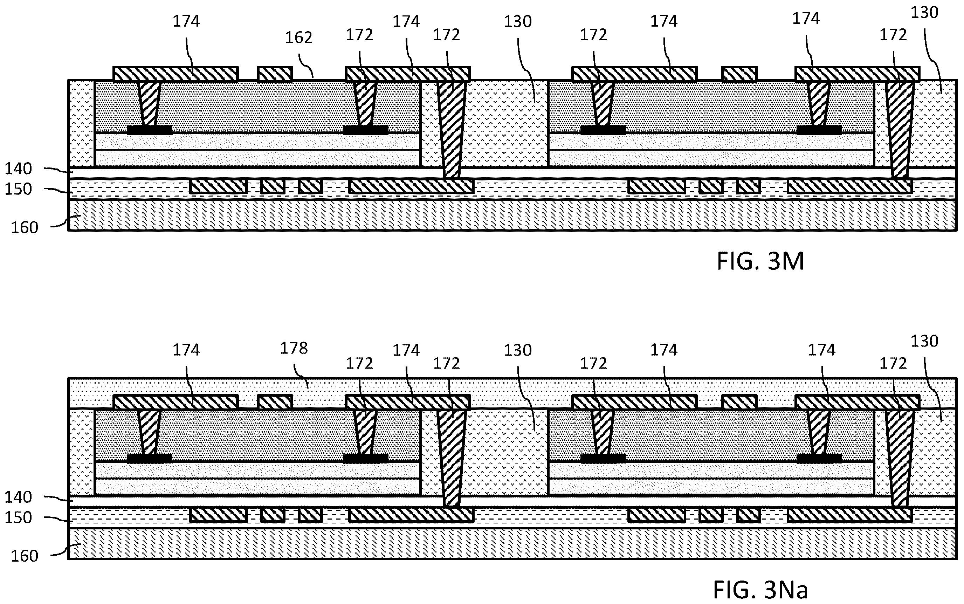

Figure 3M - using conductive material deposition (for example, sputtering, plating, etc.) and lithographic processing techniques (for example, patterning, etching, etc.), the via openings 110 and 170 are filled with conductive material to provide vias 172 and a plurality of conductive lines 174 are formed extending over the front side 162. In an embodiment, a conductive seed layer is deposited (for example, by sputtering) and lithographically patterned. A plating process is then performed to plate copper material on the lithographically patterned seed layer to fill the openings 110 and 170 providing vias 172 and form the conductive lines 174.

Figure 3Na - the structure formed by the process step shown in Figure 3M is then placed within a cavity of a two part mold and an encapsulation material 178 is injected into the cavity and allowed to cure so as to encapsulate the conductive lines 174. The panel structure formed in the molding process is removed from the mold. This processing operation is similar to that shown in Figures 3I-3J.

The conductive lines 174 and the encapsulation material 178 from the molding operation of Figure 3Na provide the structures for the lines 30a and fourth encapsulation body 30b of the second plating (redistribution) layer 30 for each package 10.

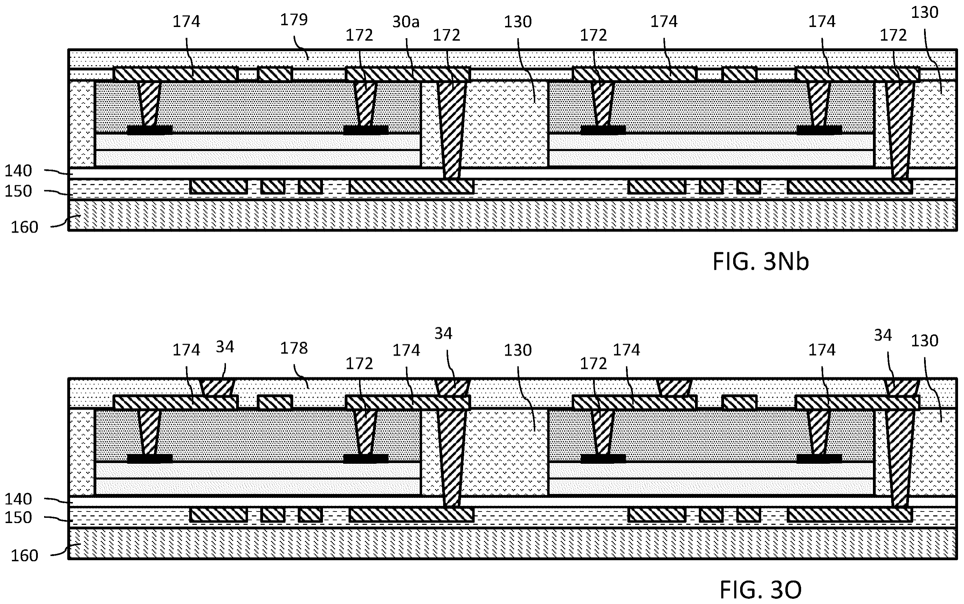

Figure 3Nb - as an alternative to the use of a molding operation, an encapsulation layer 179 may be laminated onto the front side 162. This laminated encapsulation layer 179 may cover the conductive lines 174. Alternatively, the laminated encapsulation layer 179 may be lithographically patterned with openings within which the conductive lines 174 are formed.

The conductive lines 174 and the encapsulation material from the lamination layer 179 of Figure 3Nb provide the structures for the lines 30a and fourth encapsulation body 30b of the second plating (redistribution) layer 30 for each package 10. The fourth encapsulation 30b may be provided using a number of laminated encapsulation layers 179 in a stacked configuration.

Figure 3O - vias 34 are then formed in the encapsulation 178, 179 to reach the conductive lines 174. These vias 34 may be formed in a manner similar that described herein with respect to vias 54.

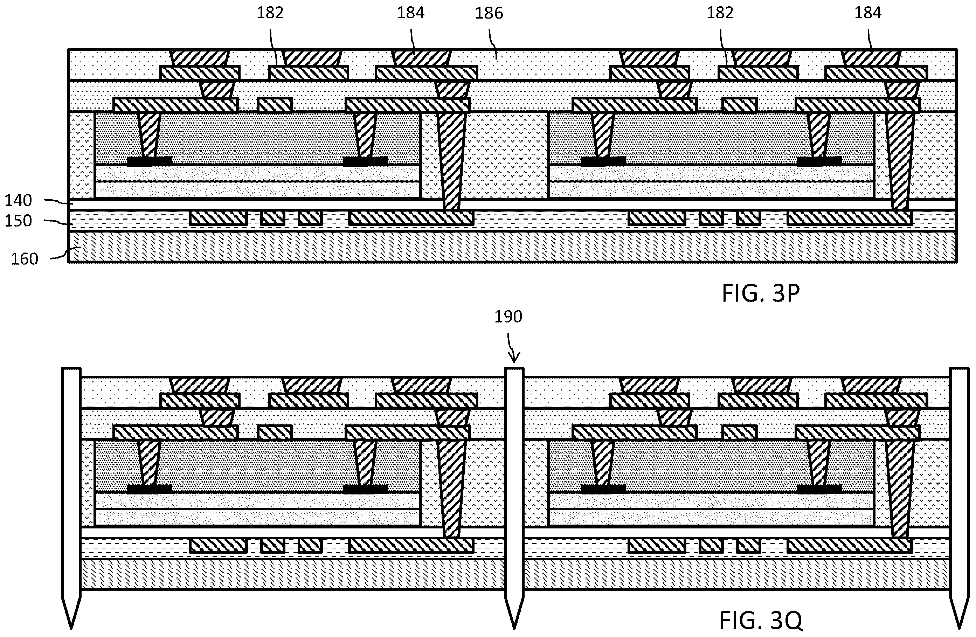

Figure 3P - the foregoing processing operations as shown in Figures 3M, 3Na or 3Nb, and 3O may then be repeated to form conductive lines 182 and vias (pads) 184 with encapsulation 186.

The conductive lines 182 and the encapsulation material 186 from the molding provide the structures for the lines 40a and fifth encapsulation body 40b of the third plating (redistribution) layer 40 for each package 10.

Figure 3Q - the panel structure is then processed in a singulation operation by cutting 190 (for example, dicing) the panel into a plurality of individual packages 10. The cutting may be performed by a sawing action taken along scribe line locations between the locations of the packages.

The bonding balls 50 may be mounted to the pads 44 at any suitable time.

While the invention has been illustrated and described in detail in the drawings and foregoing description, such illustration and description are considered illustrative or exemplary and not restrictive. Other variations to the disclosed embodiments can be understood and effected by those skilled in the art in practicing the claimed invention, from a study of the drawings, the disclosure, and the appended claims.

## Claims

1. A method, comprising:
mounting a plurality of integrated circuit (IC) dies upper face down to a first carrier panel;
placing the first carrier panel with the plurality of IC dies in a first mold cavity;
injecting an encapsulation material into the first mold cavity to laterally encapsulate the plurality of IC dies with a first encapsulating body;
forming a first plating layer over lower faces of the plurality of IC dies and first encapsulating body, said first plating layer including first conductive lines encapsulated in a second encapsulating body;
removing the first carrier panel;
mounting a second carrier panel to the second encapsulating body of the first plating layer;
forming first via openings from an upper face of the first encapsulating body through the first encapsulating body to reach back surfaces of the first conductive lines; and
forming a second plating layer over the upper face of the first encapsulating body, said second plating layer including conductive vias filling the first via openings and second conductive lines encapsulated in a third encapsulating body and electrically connected to the plurality of IC dies.

2. The method of claim 1, further comprising:
forming each IC die to include a fourth encapsulating body covering die pads of the IC die; and
forming second via openings extending through the fourth encapsulating body;
wherein the second plating layer further comprises conductive vias filling the second via openings to electrically connect to die pads of the plurality of IC dies.

3. The method of claim 1 or 2, further comprising providing an insulating dielectric layer between the first plating layer and lower faces of the plurality of IC dies and first encapsulating body, and wherein forming first via openings further comprises forming first via openings through both the first encapsulating body and the insulating dielectric layer.

4. The method of any one of claims 1 to 3, further comprising, after mounting the plurality of IC dies upper face down to the first carrier panel, performing a lower face grind to thin a semiconductor substrate of each integrated circuit die.

5. The method of any one of claims 1 to 4, further comprising forming further conductive vias extending through the third encapsulating body to connect to the second conductive lines.

6. The method of any one of claims 1 to 5, further comprising forming further conductive vias extending through the second encapsulating body to connect to the first conductive lines.

7. The method of any one of claims 1 to 6, wherein the first conductive lines form one of:
an antenna,
a redistribution layer, and
an electromagnetic shield.

8. The method of any one of claims 1 to 6, wherein the first conductive lines form a redistribution layer.

9. The method of any one of claims 1 to 8, wherein forming the first via openings comprises laser drilling the first via openings through the first encapsulating body.

10. The method of any one of claims 1 to 9, further comprising forming a third plating layer over the second plating layer, said third plating layer including third conductive lines encapsulated in a fourth encapsulating body and electrically connected to the second conductive lines.

11. The method of claim 10, further comprising:
providing ball mounting pads in the fourth encapsulating body, said ball mounting pad being in electrical connection to the third conductive lines; and
mounting bonding balls to the ball mounting pads.

12. The method of any one of claims 1 to 11, wherein upper faces of the IC dies and first encapsulating body are coplanar faces.

13. The method of any one of claims 1 to 11, wherein lower faces of the IC dies and first encapsulating body are coplanar faces.

14. The method of any one of claims 1 to 13, further comprising dicing between IC dies to form a plurality of integrated circuit packages.

15. An integrated circuit package formed by the method of claim 14.
